Europäisches Patentamt

European Patent Office

Office européen des brevets

(19)

(11) **EP 1 191 580 A1**

## (12) EUROPEAN PATENT APPLICATION
published in accordance with Art. 158(3) EPC

(43) Date of publication:
   **27.03.2002 Bulletin 2002/13**

(21) Application number: **00915400.6**

(22) Date of filing: **07.04.2000**

(51) Int Cl.7: **H01L 21/68**, H01L 21/027,
   G03F 7/20, G03F 9/00

(86) International application number:
   **PCT/JP00/02257**

(87) International publication number:
   **WO 00/65645 (02.11.2000 Gazette 2000/44)**

(84) Designated Contracting States:
   **AT BE CH CY DE DK ES FI FR GB GR IE IT LI LU
   MC NL PT SE**
   Designated Extension States:
   **AL LT LV MK RO SI**

(30) Priority: **27.04.1999 JP 12044599**

(71) Applicant: **Nikon Corporation
   Tokyo 100-8831 (JP)**

(72) Inventors:
   • **HARA, Hideaki, Nikon Corporation, I. P. Dept.
      Tokyo 100-8331 (JP)**
   • **HORIKAWA, Hiroto,
      Nikon Corporation, I. P. Dept.
      Tokyo 100-8331 (JP)**

(74) Representative: **HOFFMANN - EITLE
   Patent- und Rechtsanwälte
   Arabellastrasse 4
   81925 München (DE)**

## (54) STAGE DEVICE AND EXPOSURE DEVICE

(57)   A stage device which is composed of a coarse adjustment stage and fine adjustment stage which can be moved relative to the coarse adjustment stage and driven relative to the coarse adjustment stage with a low heat generation and a great thrust. The fine adjustment stage (3) is provided on the inner side of a recessed part (4a) in the coarse adjustment stage (4), which is scanned in a scanning direction (Y-direction) at an approximately constant speed at the time of scanning exposure, so as to be movable two-dimensionally relative to the coarse adjustment stage (4), and a reticle (R) which is an exposure object is held by attraction on the fine adjustment stage (3). The fine adjustment stage (3) is driven relative to coarse adjustment stage (4) in a non-scanning direction (X-direction) by X-axis fine adjustment motors (8A and 8B) at two positions which used Lorentz forces, and in scanning by a Y-axis fine adjustment motor (21) composed of a mover (22) which is an I-shaped core and a pair of magnets including stators (23A and 23B) which are E-shaped cores.

Fig. 3

EP 1 191 580 A1

## Description

TECHNICAL FIELD

The present invention relates to stage apparatus for precisely positioning a work-piece. This invention can be used suitably with exposure apparatus for use in transferring a mask pattern onto a wafer or another substrate at a lithography step for producing a semiconductor device, a liquid crystal display element, a thin-film magnetic head or the like. In particular, the invention can be used suitably with step-and-scan exposure apparatus.

BACKGROUND ART

Conventionally, semiconductor devices etc. have been produced mainly with stepper type reduction-projection exposure apparatus for transferring a pattern of a reticle as a mask onto a wafer (or a glass plate or the like) as a substrate, which is coated with resist. Recently, attention has been attracted by step-and-scan reduction-projection exposure apparatus for making exposure by synchronously scanning a reticle and a wafer with respect to a projection optical system in order to transfer a large-area circuit pattern onto the shot areas of the wafer without enlarging this optical system. A scanning exposure apparatus of this type includes a wafer stage and a reticle stage. The wafer stage steps in two directions perpendicular to each other and moves continuously at a constant speed in the scanning direction. The reticle stage can continuously move at a constant speed in the scanning direction, minutely or slightly move in non-scanning direction, and turn for a minute angle around an axis perpendicular to the plane of movement.

The conventional reticle stage includes a coarse-adjustment stage and a fine-adjustment stage. The coarse-adjustment stage can move a long distance in the scanning direction along a long guide by means of a long linear motor. The fine-adjustment stage can move relative to the coarse-adjustment stage finely in two dimensions. The fine-adjustment stage can be driven two-dimensionally by linear motors. The linear motors have stators and movers, which are fixed to the coarse-adjustment and fine-adjustment stages, respectively. A reticle is held by suction on the fine-adjustment stage.

In this case, the reticle includes a glass substrate, on which a master pattern for transfer is formed by portrayal or the like. The master pattern is not necessarily positioned with high accuracy on the basis of the end faces of the glass substrate. In the worst case, the parallelism between the master pattern and the substrate end faces is about 2mm/100mm (equivalent to an angle of about 1 degree). Therefore, the position of the master pattern may have relatively large errors with respect to the end faces.

In the process of loading the reticle onto the reticle stage, pre-alignment is made normally on the basis of the end faces of the glass substrate of the reticle. The results of the pre-alignment are the bases for placing the reticle on the fine-adjustment stage. This may angularly shift (displace) the coordinate system of the master pattern on the reticle relatively greatly with respect to the coordinate system of the exposure apparatus. Therefore, conventionally, after the reticle is placed on the fine-adjustment stage, the position of the alignment mark on the reticle is measured to find the angle of rotation of the reticle with respect to the coordinate system of the exposure apparatus. Then, the fine-adjustment stage is turned so as to cancel this angle of rotation.

As stated above, the reticle stage of the conventional scanning exposure apparatus includes a coarse-adjustment stage and a fine-adjustment stage. The turning of the fine-adjustment stage corrects the turning error arising when the reticle is loaded. The correction requires that the linear motors for driving the fine-adjustment stage have large strokes to cover (cope with) large angles of rotation with respect to the end faces of the glass substrate of the master pattern on the reticle.

If the fine-adjustment stage greatly turns relative to the coarse-adjustment stage, the angles between the movers and stators of its linear motors greatly change. This changes the relation between the drive current and thrust of the linear motors, so that the control characteristics of these motors may worsen. By contrast, a voice coil motor (VCM), which uses Lorentz force, is known as a motor of which the thrust does not greatly change even if the positional relation between its mover and stator changes relatively greatly. Therefore, the use of VCMs in place of the linear motors for driving the fine-adjustment stage has been studied.

By the way, it has recently been demanded to further improve the throughput of scanning exposure apparatus. This necessitates improving the scanning speeds of the wafer stage and reticle stage of the exposure apparatus. The scanning exposure apparatus may be a reduction-projection exposure apparatus. In this case, if the projection ratio (magnification) is 1/4, for example, the reticle stage needs a scanning speed four times that of the wafer stage. In order to meet such a demand for higher scanning speed, in particular, the reticle stage needs very high acceleration in the scanning direction, and the motors for driving the fine-adjustment stage need high thrust.

In this respect, a VCM provides substantially constant thrust even if the positional relation between its mover and stator shifts relatively greatly, but its efficiency of utilization of drive current is low. Therefore, in order to provide high thrust by means of a VCM, it is necessary to make a powerful electric current run, or to make the magnet and coil larger in size. However, the powerful current results in increased heat generation, which may lower the accuracy of position measurement of the laser interferometer for measuring the position of the reticle stage. The larger magnet and coil increase the weight of the VCM. The increased weight may deform the fine-adjustment stage, which needs to support a reticle with high parallelism.

For higher throughput, the reticle stage may be accelerated at higher acceleration than a conventional reticle stage. In this case, if the attraction force for a reticle is the same as that in conventional reticle stage, the inertia force acting on the reticle may offset the reticle from a certain position on the reticle stage. The attraction force for a reticle is nearly proportional to the area of that contact part of the suction surface of the reticle which faces a groove for suction. The area of the contact part is difficult to enlarge. In order to prevent the reticle from deforming, it is preferable that the attraction force of the suction pump should not be very large. Therefore, it has been demanded to provide a reticle fixing method which increases the attraction force to the reticle without enlarging the area of the contact parts for mutual contact of the reticle and the suction device.

In view of the foregoing points, it is a first object of the present invention to provide a stage apparatus which may include a coarse-adjustment stage and a fine-adjustment stage which is movable relative to the coarse-adjustment stage, and which can drive the fine-adjustment stage relative to the coarse-adjustment stage with low heat generation and great thrust.

It is a second object of the present invention to provide a stage apparatus which may include a coarse-adjustment stage and a fine-adjustment stage which is movable relative to the coarse-adjustment stage, and which can substantially increase the angle of rotation of the fine-adjustment stage without increasing the range of relative movement this stage.

It is a third object of the present invention to provide a stage apparatus which can hold an object to be carried such as a reticle with great attraction force and without increasing the area of the contact part of the object.

It is a fourth object of the present invention to provide a stage apparatus which can drive a stage stably at high speed.

It is part of a fifth object of the present invention to provide an exposure apparatus which includes such a stage apparatus, and which can perform scanning exposure at high speed with high accuracy. It is the other part of the fifth object to provide a method for producing high precision devices at high throughput by means of such an exposure apparatus.

DISCLOSURE OF THE INVENTION

A first stage apparatus according to the present invention includes a coarse-adjustment stage (4) and a fine-adjustment stage (3). The coarse-adjustment stage (4) is supported so as to be movable relative to a base (5) within a stroke in a predetermined direction. The fine-adjustment stage (3) is supported so as to be movable relative to the coarse-adjustment stage within a stroke shorter than the stroke of the coarse-adjustment stage at least in the predetermined direction. The stage apparatus also includes a magnetic substance (22) fixed to one (4) of the two stages and arranged in a direction substantially perpendicular to the predetermined direction. The stage apparatus further includes a pair of electromagnetic members (23A, 24A, 23B, 24B) fixed to the other (3) of the two stages. The electromagnetic members develop driving force on the magnetic substance.

By controlling the attraction force which the pair of electromagnetic members apply to the magnetic substance, it is possible to make a predetermined thrust act between the magnetic substance and the electromagnetic members. By narrowing the space between the magnetic substance and the electromagnetic members, it is possible to generate great thrust with weak current, that is to say, with low heat generation. This thrust can move the fine-adjustment stage relative to the coarse-adjustment stage at high acceleration.

The magnetic substance (22) should preferably be fixed as a mover on the fine-adjustment stage. The pair of electromagnetic members should preferably be fixed as stators on the coarse-adjustment stage. Each of the electromagnetic members should preferably have an E-shaped core (23A, 23B) and a coil (24A, 24B) wound on the core. Part of the magnetic substance can be regarded as an I-shaped core. If the space between the I-shaped and E-shaped cores is, for example, about 0.2 - 0.5 mm, it is possible to generate high thrust with particularly weak current.

However, if the space between the I-shaped and E-shaped cores is narrow, there may be no room for the fine-adjustment stage to turn relative to the coarse-adjustment stage beyond some degree. It is therefore preferable that a turning mechanism be provided for turning the coarse-adjustment stage so that the turning of this stage may substantially make the fine-adjustment stage rotatable.

Specifically, it is preferable that the stage apparatus further include a guide (6) disposed so as to be movable relative to the base (5) in the predetermined direction, a rotational support (7) for supporting the coarse-adjustment stage rotatably relative to the guide, and a pair of driving units (13A, 13B) for driving the coarse-adjustment stage out of contact with the base in the predetermined direction.

A second stage apparatus according to the present invention includes a base (5) and a movable stage (3, 4) disposed so as to be movable relative to the base in a predetermined direction. An object to be carried (carried object) (R) can be mounted on the movable stage. This stage apparatus also includes a vacuum suction device and an electrostatic attraction device (54, 61, 62). The vacuum suction device includes an opening (51a) formed in part of a contact surface for contact with the carried object of the movable stage and a suction apparatus (60) for sucking gas from the opening. The electrostatic attraction device includes an electrode (54) disposed in the opening. The suction and attraction devices are used together to fix the carried object to the movable stage.

The second stage apparatus fixes the carried object with attraction force, which is supplemented with electrostatic attraction force. In general, if the humidity (steam) in surrounding gas rises, electrostatic attraction force decreases. Accordingly, if the gas surrounding the carried object is ordinary air, only the electrostatic attraction force might not be sufficient for the object to be sucked. If the electrode for electrostatic attraction were provided outside a groove for suction (a vacuum pocket), the area of the contact part in contact with the carried object would increase. Therefore, the electrode for electrostatic attraction is provided in a groove for suction to increase the attraction force to the carried object without enlarging the area of the contact part.

If electrostatic attraction is applied to the carried object surrounded by air or other gas, electric charge may remain in the attraction parts of this object and the movable stage when the object is removed from the stage. The remaining charge may attract dust and other foreign substances suspending in the surrounding gas. In order to avoid the attraction of such foreign substances, it is preferable that a charge eliminator such as an ionizer be provided.

A first exposure apparatus according to the present invention includes a mask stage apparatus and a substrate stage apparatus. The mask stage apparatus moves while holding a mask (R) thereon on which a pattern is formed. The substrate stage apparatus moves while holding a substrate (W) thereon. The exposure apparatus exposes the substrate with the pattern. The first or second stage apparatus is used as at least one of the mask stage apparatus and the substrate stage apparatus.

The first exposure apparatus successively transfers the pattern on the mask onto the substrate by the scanning exposure method (on the scanning exposure system), for example. If the first stage apparatus is used for this exposure apparatus, it is possible to move the fine-adjustment stage finely at high speed with high accuracy, thereby restraining the follow-up error even if the scanning speed increases. If the second stage apparatus is used for the exposure apparatus, the attraction force to the mask or the substrate is increased. Consequently, even when the movable stage moves at high speed, the mask or the substrate does not cause positional discrepancy. In either case, it is possible to reduce the superposition error and improve the throughput.

A third stage apparatus according to the present invention includes a stage (3, 4) movable in a predetermined direction. This stage apparatus also includes a driving unit (13A, 13B) for driving the movable stage in the predetermined direction. The drive includes a first mover and a second mover (14A, 14B) both provided on the movable stage. The driving unit also includes a first stator and a second stator (15A, 15B) for cooperating with the first mover and the second mover, respectively. The stage apparatus further includes a first balance stage (18A) and a second balance stage (18B), which move in the direction opposite to the predetermined direction as the movable stage moves. The first balance stage is fixed to the first stator. The second balance stage is fixed to the second stator and provided independently of the first balance stage.

By moving the first and second balance stages in the direction opposite to the direction in which the movable stage moves, it is possible to move the movable stage at high speed with little vibration. Because each of the balance stages is provided independently of the other, a minute or slight difference in thrust between them develops no rotation moment on the movable stage. This makes it possible to drive the movable stage stably at high speed.

It is preferable that the third stage apparatus include position-adjusting mechanism (43A, 44A, 44B) for adjusting the position of one of the first and second balance stages (18A, 18B).

It is preferable that the position-adjusting mechanism includes a position detector (40A, 40B) for detecting the position of one of the first and second balance stages.

It is preferable that the position-adjusting mechanism includes a second drives (45A, 45B) for driving the first and second balance stages.

The movable stage (3, 4) moves on a plane (5a), and the first and second balance stages (18A, 18B) move on planes (5c, 5d), which should preferably differ from the plane (5a).

It is preferable that the third stage apparatus include a support (5, 19A, 20A, 19B, 20B) for movably supporting the movable stage and the first and second balance stages.

It is preferable that the third stage apparatus include a stage position detector (27, 30, 28A, 28B, 29A, 29B, 31A, 31B, 32A, 32B) for detecting the position of the movable stage, which should preferably be fitted with at least part (27, 28A, 28B, 29A, 29B) of the detector.

It is preferable that the movable stage includes a first stage (4) fitted with the first and second movers, and a second stage (3) movable relative to the first stage. In this case, it is possible to scan the movable stage at high speed. It is also possible to correct at high speed the synchronization error when moving the movable stage synchronously with the other stage.

It is preferable that the third stage apparatus include a magnetic substance (22) fitted to the second stage and an electromagnetic member (23A, 23B) for developing driving force on the magnetic substance. The electromagnetic member should preferably be fitted to the first stage. In this case, it is possible to position the second stage finely and stably at high speed of response.

A second exposure apparatus according to the present invention includes a mask stage and a substrate stage. The mask stage moves while holding a mask (R) thereon on which a pattern is formed. The substrate stage moves while holding a substrate (W) thereon. This exposure apparatus exposes the substrate with the pattern. The third stage apparatus is used as at least one of the mask stage and the substrate stage.

By using the third stage apparatus in the second exposure apparatus, it is possible to drive the movable stage stably at high speed, reduce the superposition error and improve the throughput.

A device manufacturing method according to the present invention is a method for manufacturing a device through an exposure process for exposing a substrate with a mask pattern. The exposure process is carried out by the first or second exposure apparatus. By using the first or second exposure apparatus, this method makes it possible to manufacture high-precision devices at high throughput.

BRIEF DESCRIPTION OF THE DRAWINGS

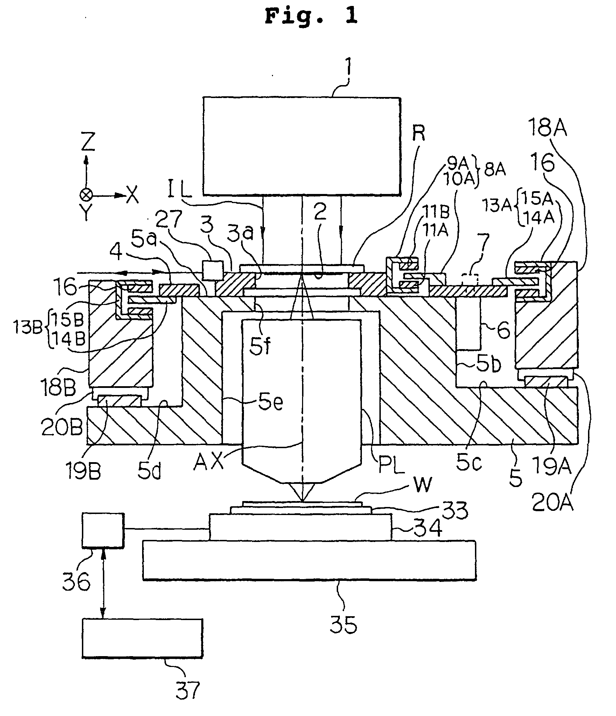

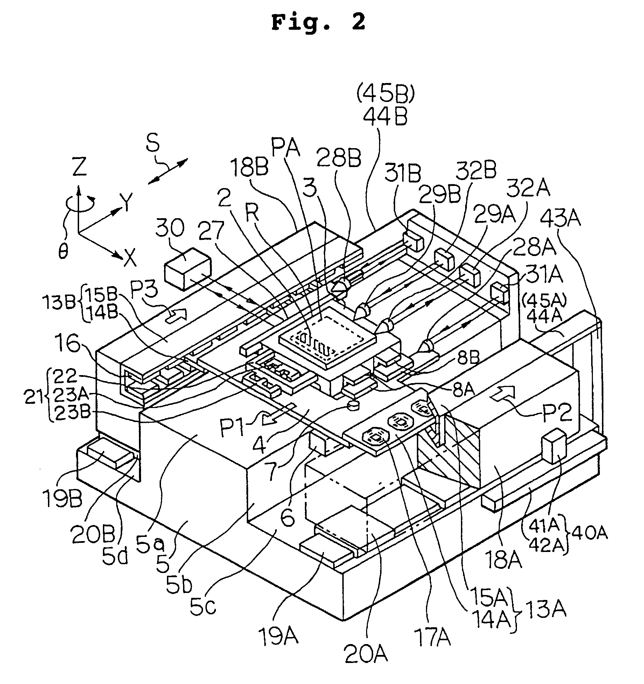

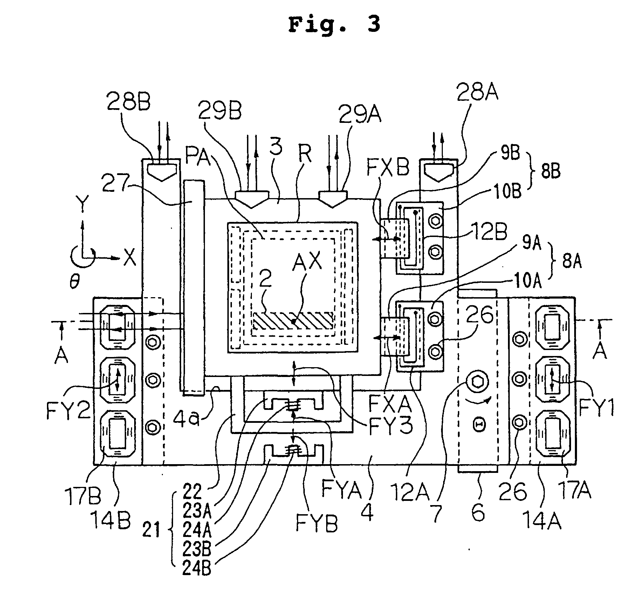

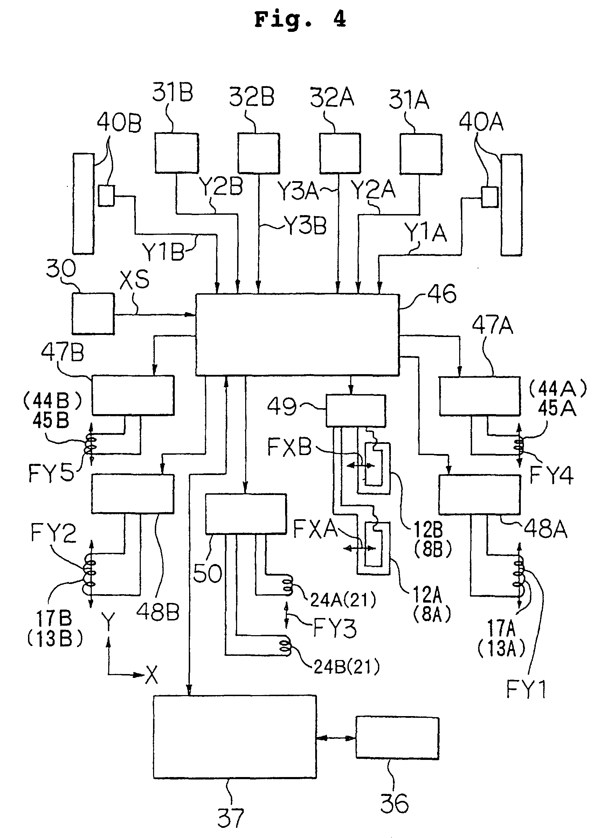

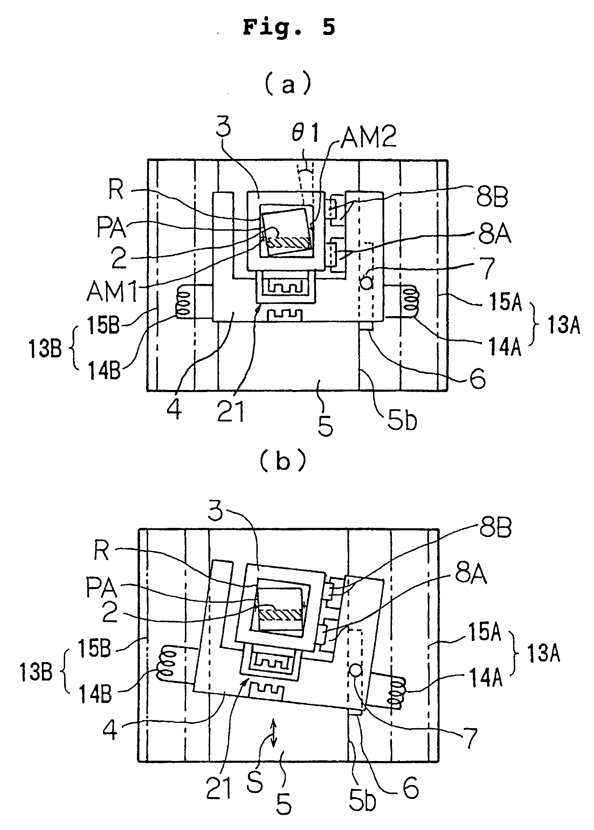

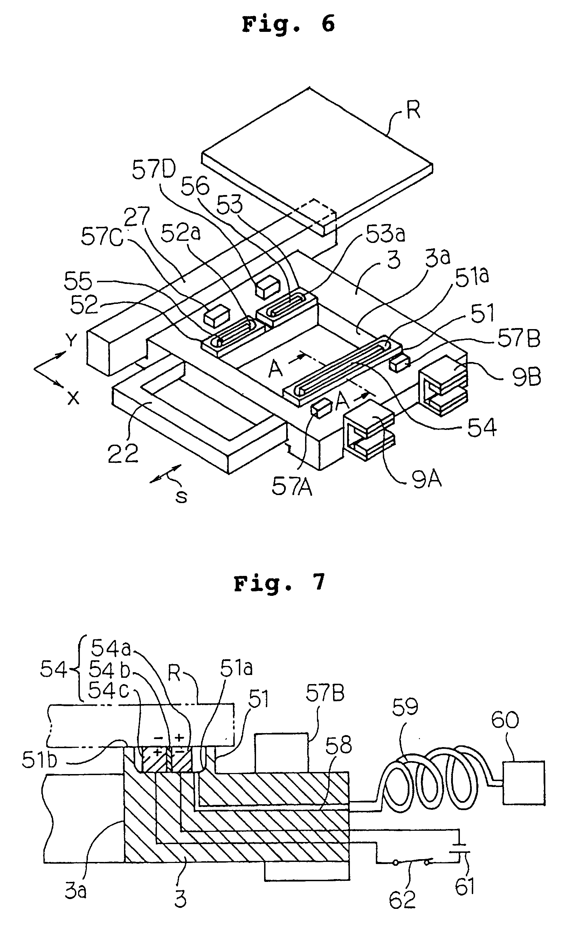

Fig. 1 is a partially broken schematic diagram showing a projection exposure apparatus embodying the present invention. Fig. 2 is a partially broken perspective view showing a drive mechanism and a measuring mechanism for the reticle stage shown in Fig. 1. Fig. 3 is a plan view showing the reticle stage shown in Fig. 2. Fig. 4 is a block diagram showing a control system for the stage system of the projective exposure apparatus. Fig. 5 is explanatory views showing the action of turning the coarse-adjustment stage 4 to cancel the turning error of the master pattern of a reticle R. Fig. 6 is a perspective view showing the fine-adjustment stage 3 of the reticle stage with the reticle R removed from the stage 3. Fig. 7 is an enlarged cross section along line A-A of Fig. 6.

BEST MODE EMBODYING THE INVENTION

A preferred embodiment of the present invention will be described below with reference to the drawings. This embodiment is a step-and-scan projection exposure apparatus, to which the invention is applied.

Fig. 1 is a schematic diagram showing the structure of the projection exposure apparatus part of which is shown as cross section. Fig. 2 is a perspective view showing the structure of the reticle stage of the projection exposure apparatus. With reference to Fig. 1, a lighting optical system 1 is provided over a reticle R for transfer. The projection exposure apparatus is housed in a chamber (not shown), outside which an exposure light source (not shown) is provided. The lighting optical system 1 includes an optical integrator, which may be a fly-eye lens, for making uniform the illumination distribution of the exposure light from the exposure light source. The lighting optical system 1 also includes a variable-field stop, which may be a reticle blind, and a condenser lens. During exposure, the exposure light IL from the lighting optical system 1 illuminates the pattern side (underside) of the reticle R within a narrow rectangular lighting area 2. The exposure light IL may be a bright (emission) line such as an i-line from a mercury lamp, an excimer laser beam such as KrF (wavelength: 248 nm) or ArF (wavelength: 193 nm), an $F_2$ laser beam (wavelength: 157 nm), or a higher harmonic from a YAG laser.

An image of the pattern in the lighting area 2 of the reticle R is projected on a reduced scale at a projection ratio (magnification) β, which may be 1/4 or 1/5, through a projection optical system PL onto a wafer W as a substrate, which is coated with photoresist. The wafer W is a substrate in the form of a disk, which may be a semiconductor (silicon or the like) or SOI (silicon on insulator) . The projection optical system PL has an optical axis AX. The projection exposure apparatus will be described below with a Z axis parallel to the optical axis AX, an X axis parallel to Fig. 1, and a Y axis perpendicular to Fig. 1, the X and Y axes extending on a substantially horizontal plane perpendicular to the Z axis. The lighting area 2 on the reticle R is a narrow rectangle in the form of a slit, which extends in the X direction. During scanning exposure, the reticle R and wafer W are scanned in the Y direction.

A fine-adjustment stage 3 has an opening 3a formed through a center portion thereof, over which the reticle R is held on this stage 3 by attraction force. During exposure, the fine-adjustment stage 3 continuously moves together with a coarse-adjustment stage 4 in the Y direction on a reticle base 5. As the need arises, the fine-adjustment stage 3 turns around an axis parallel to the Z axis (hereinafter simply referred to as "around Z axis"). As the need arises, the fine-adjustment stage 3 moves relative to the coarse-adjustment stage 4 within narrow ranges in the X and Y directions, and turns relative to the stage 4 within a narrow angular range around the Z axis. The reticle base 5 has a cavity 5e formed on the underside thereof, in which a substantial portion of the projection optical system PL is housed. The reticle base 5 also has an opening 5f formed therethrough at a center portion of the cavity 5e. The lighting area 2 of the reticle R is positioned over the opening 5f. The two-dimensional positions of the fine-adjustment stage 3 (reticle R) and coarse-adjustment stage 4 are measured with high accuracy by laser interferometers as position detectors. The values measured by the laser interferometers are supplied to a reticle stage drive system 46 and a main control system 37 as shown in Fig 4, respectively. The reticle stage drive system 46 controls the operation of the two stages 3 and 4 on the basis of the measured values, the control information from the main control system 37, and other control information.

The stages 3 and 4 constitute the reticle stage. The structure and operation of the reticle stage, and a mechanism for sucking the reticle R onto the fine-adjustment stage 3 will be described later on in detail.

The wafer W is held with a wafer holder 33 on a wafer stage 34 by attraction force. During scanning exposure, the wafer stage 34 moves continuously on a wafer base 35 in the Y direction on the linear motor system. As the need arises, the wafer stage 34 steps in the X and Y directions on the linear motor system. The wafer stage 34 has a Z-tilt mechanism for controlling the focal positions (along the optical axis AX) and the tilt angle of the wafer W. An oblique-incidence autofocus sensor (not shown) is provided for detecting the focal positions of the surface of the wafer W at a plurality of the measuring points in the exposure area and a pre-read area on the wafer W. The pre-read area is located ahead of the exposure area in the scanning direction. On the basis of the values measured by this autofocus sensor, the wafer stage 34 adjusts the height of the surface of the wafer W to meet with the image surface of the projection optical system PL continuously on the autofocus system during scanning exposure.

The positions of the wafer stage 34 in the X and Y directions are measured with high accuracy by laser interferometers (not shown) as a position detector. The measured values are supplied to the wafer stage drive system 36 and main control system 37. The wafer stage drive system 36 controls the operation of the wafer stage 34 on the basis of the measured values and the control information from the main control system 37. The wafer base 35 lies on a surface plate or table (not shown), which may be placed with a plurality of vibration-eliminating pedestals on a floor. This surface plate supports columns (not shown) embedded therein, to which the projection optical system PL and reticle base 5 are fixed.

During exposure, after one shot area on the wafer W is exposed, the wafer stage 34 is caused to step, moving the next shot area on the wafer W to the scanning starting position. Thereafter, the reticle stage (fine-adjustment stage 3 and coarse-adjustment stage 4) and the wafer stage 34 are driven synchronously, and the reticle R and the wafer W are scanned synchronously in the Y direction relative to the projection optical system PL at the speed ratio which is the projection ratio β. These operations are repeated on the step-and-scan system during exposure. During the operations, while the synchronization errors between the reticle R and wafer W are reduced by, for example, the fine driving of the fine-adjustment stage 3 relative to the coarse-adjustment stage 4, the pattern image in the pattern area of the reticle R is transferred successively to the shot areas of the wafer W.

The structure and operation of the reticle stage will be described below in detail. With reference to Fig. 1, the top of the reticle base 5 is used as a horizontal guide surface 5a substantially parallel to a horizontal plane. One side face of the reticle base 5, which is perpendicular to the top of this base, is used as a vertical guide surface 5b substantially parallel to a vertical plane. The vertical guide surface 5b extends on a plane (substantially a YZ-plane) where an axis parallel to the Y axis and an axis substantially parallel to the Z axis extend. The reticle base 5 has spaces (recesses) formed on both sides. The bottoms of these spaces are used as drive motor supporting surfaces 5c and 5d substantially parallel to a horizontal plane. The horizontal guide surface 5a and vertical guide surface 5b are very smoothly finished flat surfaces. The fine-adjustment stage 3 and coarse-adjustment stage 4 are supported in parallel on the non-contact bearing system over the horizontal guide surface 5a.

The fine-adjustment stage 3 is fitted with three or more air ejecting portion of an air bearing (not shown) at the bottom thereof, which eject a gas (air, helium or nitrogen gas, or the like) downward onto the horizontal guide surface 5a. The fine-adjustment stage 3 is supported over and out of contact with the horizontal guide surface 5a movably in the X and Y directions and rotatably on the axis parallel to the Z axis. The coarse-adjustment stage 4 has an area on the bottom thereof which faces the horizontal guide surface 5a. Likewise, this bottom area is fitted with three or more air ejecting portions of an air bearing (not shown). The coarse-adjustment stage 4 is supported in a non-contact fashion on the air bearing system rotatably in a direction Θ (Fig. 3) on a shaft 7, which is parallel to the Z axis, relative to a Y-axis slider 6. The Y-axis slider 6 is free to move along the vertical guide surface 5b in the Y direction. This arrangement enables the coarse-adjustment stage 4 to move in the Y direction along the vertical guide surface 5b and rotate in the direction Θ on the shaft 7.

That surface of the Y-axis slider 6 which faces the vertical guide surface 5b is formed with ejecting portions (not shown), which are connected to a compressor (not shown) to eject gas. This slider surface is also formed with grooves for suction (vacuum pockets) (not shown), which are connected to a vacuum pump (not shown). By keeping a balance between the pressure of the gas ejected from the ejecting portions and the attraction force (pre-load) from the grooves for suction, the Y-axis slider 6 moves smoothly in the Y direction along and out of contact with the vertical guide surface 5b, with a predetermined gap kept between the slider 6 and the surface 5b. In other words, the Y-axis slider 6 and vertical guide surface 5b are coupled to each other with the predetermined gap kept constantly by a vacuum pre-load air bearing.

Fig. 2 is a partially broken perspective view showing a drive mechanism and a measuring mechanism for the reticle stage shown in Fig. 1. Fig. 3 is a plan view showing the reticle stage shown in Fig. 2. Fig. 4 is a block diagram showing the drive system of the reticle stage. Fig. 1 shows some parts in section along line A-A of Fig. 3. With reference to Fig. 3, the coarse-adjustment stage 4 is generally F-shaped and has a deep recess 4a, in which the fine-adjustment stage 3 is disposed movably independent of the stage 4. With reference to Fig. 2, motor guides 19A and 19B in the form of narrow flat plates are fixed in parallel with the Y axis on the drive motor supporting surfaces 5c and 5d, respectively, on both sides of the reticle base 5. Air sliders 20A and 20B are supported on the air bearing system over and out of contact with the motor guides 19A and 19B, respectively, movably in the Y direction. As shown partially with two-dot chain lines, motor balancers 18A and 18B in the form of blocks, which are long in the Y direction, are fixed on the air sliders 20A and 20B, respectively. As shown in Fig. 1, stators 15A and 15B are fixed in the inner recesses of the motor balancers 18A and 18B, respectively. The stators 15A and 15B are U-shaped in section and narrow, and extend in the Y direction. The stators 15A and 15B are made of magnetic substance (iron frames or the like) . The stators 15A and 15B include permanent magnets 16 as magnetism generators fixed therein periodically at a predetermined pitch in the Y direction. Movers 14A and 14B are disposed in the stators 15A and 15B, respectively, and include coils disposed thereon periodically at a predetermined pitch in the Y direction. Inner side portions of the movers 14A and 14B are fixed with bolts 26 (Fig. 3) on +X-direction and -X-direction end portions, respectively, of the coarse-adjustment stage 4.

The mover 14A and stator 15A compose a first Y-axis coarse-adjustment linear motor 13A. The mover 14B and stator 15B compose a second Y-axis coarse-adjustment linear motor 13B. The pair of Y-axis coarse-adjustment linear motors 13A and 13B drives the coarse-adjustment stage 4 relative to the reticle base 5 in the Y direction. As shown in Fig. 3, the movers 14A and 14B include coils 17A and 17B, respectively, disposed thereon at a predetermined pitch. The reticle stage drive system 46 (Fig. 4), which consists of a computer, supplies the coils 17A and 17B with drive currents through drivers 48A and 48B, respectively. By controlling the drive currents, the thrusts FY1 and FY2 developing in the Y direction on the movers 14A and 14B, respectively, are controlled.

Returning to Fig. 2, during scanning exposure, the coarse-adjustment stage 4 moves in the Y direction substantially together with the fine-adjustment stage 3. When the Y-axis coarse-adjustment linear motors 13A and 13B drive the coarse-adjustment stage 4 in the Y direction, the reaction force moves the motor balancers 18A and 18B, which correspond to the balancers of the present invention, in the opposite direction to the moving direction of the coarse-adjustment stage 4 for conservation of momentum. While the coarse-adjustment stage 4 is moving in the Y direction, the fine-adjustment stage 3 and the movers 14A and 14B move substantially together with it. The total mass of the coarse-adjustment stage 4 and the members moving substantially together with it is assumed to be M1. While the motor balancers 18A and 18B are moving in the Y direction, the air sliders 20A and 20B and the stators 15A and 15B move substantially together with them. The total mass of the motor balancers 18A and 18B and the members moving substantially together with them is assumed to be M2. The mass M2 is set at about K times the mass M1 as expressed below. It is preferable that K should range from 5 to about 20. In this embodiment, K is set at about 10.

$$M1:M2 \fallingdotseq 1:K \qquad (1)$$

Consequently, when the Y-axis coarse-adjustment linear motors 13A and 13B move the coarse-adjustment stage 4 together with the fine-adjustment stage 3 at a speed P1 in a scanning direction S (Y direction), the motor balancers 18A and 18B move at lower speeds P2 and P3, respectively, which are about 1/K of the speed P1, in the opposite direction to the moving direction of the coarse-adjustment unit stage 4. The adoption of such a counter balance system results in generation of substantially no vibration even if the coarse-adjustment stage 4 is driven at high speed in the scanning direction during scanning exposure. The motor balancer 18A has a detector 41A fixed thereto. The reticle base 5 has a scale 42A fixed thereto. The detector 41A and the scale 42A compose a linear encoder 40A as a position sensor, which has a resolution of several micrometers. The linear encoder 40A measures the amount of displacement Y1A of the motor balancer 18A relative to the reticle base 5. The amount of displacement Y1A is supplied to the reticle stage drive system (Fig. 4). A similar linear encoder 40B (Fig. 4) is provided between the other motor balancer 18B and the reticle base 5. The amount of displacement Y1B measured by the linear encoder 40B is supplied to the reticle stage drive system 46. This enables the reticle stage drive system 46 to always recognize the positions, which may be approximate, of the motor balancers 18A and 18B relative to the reticle base 5.

Positioning plates 44A and 44B are inserted into the +Y-direction ends of the stators 15A and 15B of the motor balancers 18A and 18B, respectively. The positioning plates 44A and 44B include coils 45A and 45B, respectively, which are supplied with drive currents from the reticle stage drive system 46 (Fig. 4) through drivers 47A and 47B, respectively. The positioning plates 44A and 44B are fixed to the reticle base 5 by a support 43A etc. The positioning plates 44A and 44B and the stators 15A and 15B respectively compose other linear motors. For example, if the motor balancers 18A and 18B deflect excessively in the +Y or -Y direction, the reticle stage drive system 46 centers them back by controlling the currents supplied to the coils 45A and 45B of the positioning plates 44A and 44B. The linear encoders 40A and 40B measure the positions of the motor balancers 18A and 18B, which are the positions of the stators 15A and 15B of the Y-axis coarse-adjustment linear motors 13A and 13B, respectively. The information on these positions is used also to set the timing of switching the currents supplied to the coils 17A and 17B on the movers 14A and 14B, that is to say, the timing of the commutation of the linear motors.

For example, on the XZ-plane in Fig. 1, the motor balancers 18A and 18B are shown as having centers of gravity below those of the stators 15A and 15B, respectively. Practically, however, in order to restrain torque from developing on the motor balancers 18A and 18B, it is preferable that they be so shaped that, on the XZ-plane, the centers of gravity of the motor balancers 18A and 18B coincide with the points where the Y-axis coarse-adjustment linear motors 13A and 13B, respectively, develop thrusts, that is to say, the centers of the permanent magnets in the stators 15A and 15B, respectively. In this embodiment, the two motor balancers 18A and 18B are independent of each other. This prevents the coarse-adjustment stage 4 from developing rotation moments by the minute differences in thrust arising when the motor balancers 18A and 18B move to satisfy the principle of conservation of momentum. Consequently, the coarse-adjustment stage 4 can be driven stably. However, for application to an exposure apparatus which does not need very high exposure accuracy, the two motor balancers 18A and 18B might take the form of a single frame to lower the cost of production.

A drive mechanism for driving the fine-adjustment stage 3 relative to the coarse-adjustment stage 4 will be described below in detail. With reference to Fig. 1, the coarse-adjustment stage 4 has a stator 10A fixed thereto by bolts 26 (Fig. 3) and having a coil. The fine-adjustment stage 3 has a mover 9A fixed to the +X-direction end thereof. The mover 9A is U-shaped in section, and has a top and a bottom positioned respectively over and under the stator 10A. The mover 9A has permanent magnets 11A and 11B as magnetism generators fixed on the inside thereof. The permanent magnets 11A and 11B are positioned respectively under and over the stator 10A. The stator 10A and the mover 9A compose a first X-axis fine-adjustment motor 8A.

With reference to Fig. 3, a second X-axis fine-adjustment motor 8B is provided apart from the first X-axis fine-adjustment motor 8A with a certain interval in the Y direction. The second X-axis fine-adjustment motor 8B consists of a stator 10B fixed to the coarse-adjustment stage 4 and a mover 9B fixed to the fine-adjustment stage 3. The mover 9B has permanent magnets fixed on the inside thereof. The permanent magnets (11A, 11B, etc.) of the movers 9A and 9B generate magnetic flux, which may be directed in the +Z-direction, in the stators 10A and 10B, respectively. The stators 10A and 10B are fitted with coils 12A and 12B, respectively, in such a manner that the coils cross in the Y direction the magnetic fluxes generated by the movers 9A and 9B. The supply of currents to the coils 12A and 12B causes Lorentz force to develop thrusts FXA and FXB, respectively, in the X direction between the stators 10A and 10B and the movers 9A and 9B, respectively, that is to say, in the fine-adjustment stage 3 relative to the coarse-adjustment stage 4. The two X-axis fine-adjustment motors 8A and 8B are non-contact motors for operation with Lorentz force. By controlling the polarity and magnitude of the current supplied to each of the coils 12A and 12B, it is possible to independently control the direction and magnitude of each of the thrusts FXA and FXB, respectively.

With reference to Fig. 4, the reticle stage drive system 46 controls through the driver 49 the currents supplied to the coils 12A and 12B. By adjusting the magnitude of and the balance between the thrusts FXA and FXB, it is possible to move the fine-adjustment stage 3 relative to the coarse-adjustment stage 4 in the X direction, and minutely turn the fine-adjustment stage 3 around the axis parallel with the Z axis. Because the movers 9A and 9B are free to shift relative to the stators 10A and 10B, respectively, in the Y direction, the X-axis fine-adjustment motors 8A and 8B have no constraining (restraining) force in the Y direction.

With reference to Fig. 3, the fine-adjustment stage 3 has a mover 22 in the form of a handle, which is fixed to the - Y-direction end thereof. The coarse-adjustment stage 4 has a pair of E-shaped stators 23A and 23B fixed on the top thereof. The mover 22 and the stators 23A and 23B are made of magnetic substance. The mover 22 includes an I-shaped middle portion, which is positioned between the stators 23A and 23B in the Y direction. The stators 23A and 23B include center protrusions, on which coils 24A and 24B are wound respectively. The mover 22, the stators 23A and 23B, and the coils 24A and 24B compose a Y-axis fine-adjustment motor 21. The mover 22 is composed of a number of thin silicon steel plates as magnetic substances stacked vertically. Likewise, the stators 23A and 23B are each composed of a number of E-shaped thin silicon steel plates stacked vertically. Alternatively, the stators 23A and 23B might each include a pair of U-shaped members divided on the right and left sides with respect to a center line. The U-shaped members are each composed of a number of U-shaped thin silicon steel plates stacked vertically and closely to those of the other member. With reference to Fig. 4, the reticle stage drive system 46 supplies drive currents through a driver 50 to the coils 24A and 24B on the stators 23A and 23B. In other words, the stators 23A and 23B act as E-shaped cores (E cores), while the middle portion of the mover 22 acts as an I-shaped core (I core) substantially parallel with the X axis. Therefore, the Y-axis fine-adjustment motor 21 may be referred to as an "EI-core motor".

The polarities of the currents supplied to the coils 24A and 24B are so set that the forces which the electromagnets including the stators 23A and 23B as E cores apply to the mover 22 as an I core are attraction forces FYA and FYB, respectively, in parallel with the Y axis. The vectorial sum of the attraction forces FYA and FYB is a thrust FY3, which acts in the Y direction on the fine-adjustment stage 3 relative to the coarse-adjustment stage 4. Even in the case of the fine-adjustment stage 3 being kept stationary with respect to the coarse-adjustment stage 4, the attraction forces FYA and FYB are each set at the same value which is not lower than a predetermined value, so that the fine-adjustment stage 3 is coupled to the coarse-adjustment stage 4 with considerably high rigidity (holding power) in the Y (scanning) direction. Consequently, even if the coarse-adjustment stage 4 is scanned at high speed in the Y direction, the fine-adjustment stage 3 is scanned in the Y direction at substantially the same speed as the coarse-adjustment stage 4.

Because the attraction forces FYA and FYB are parallel with the Y axis, the Y-axis fine-adjustment motor 21 develops no constraining force in the X direction. Consequently, the fine-adjustment stage 3 is driven relative to the coarse-adjustment stage 4 in the Y direction by the thrust FY3 of only the Y-axis fine-adjustment motor 21, and in the X direction and around the axis parallel with the Z axis by the thrusts FXA and FXB of only the biaxial X-axis fine-adjustment motors 8A and 8B. The space between the mover 22 and each adjacent end of the stators 23A and 23B, when the mover is positioned in the middle between the stators, is set at about 0.2 - 0.5 mm. The moving stroke in the Y direction of the fine-adjustment stage 3 relative to the coarse-adjustment stage 4 is about 0.2 - 0.5 mm. This stroke range is enough because the fine-adjustment stage 3 is driven relative to the coarse-adjustment stage in the Y direction in order to reduce the synchronization error during scanning exposure. If the space between the mover 22 and each adjacent end of the stators 23A and 23B is wider than about 0.5 mm, the attraction forces FYA and FYB are smaller at the level of drive current easy to handle in the present circumstances. This lowers the coupling rigidity of the fine-adjustment stage 3 relative to the coarse-adjustment stage 4, and weakens the thrust FY3 for driving the fine-adjustment stage 3 to reduce the synchronization error, so that the time required for reducing this error may exceed the tolerance.

Even if the space between the mover 22 and each adjacent end of the stators 23A and 23B is set at a value larger than about 0.5 mm, it is possible to obtain necessary rigidity and thrust by supplying more powerful currents to the coils 24A and 24B, or using higher-performance magnetic substance as the mover 22 and the stators 23A and 23B. If more powerful currents flow through the coils 24A and 24B, speeds of response may be lower. This necessitates increasing the speed of response of the driver 50 (Fig. 4) in particular. In order to reduce the influence of the heat generation from the coils 24A and 24B, it is preferable that the characteristics of heat radiation of the coarse-adjustment stage 4 be improved.

If the fine-adjustment stage 3 is turned relative to the coarse-adjustment stage 4 by changing the balance between the thrusts FXA and FXB of the biaxial X-axis fine-adjustment motors 8A and 8B, as stated above, the space between the mover 22 and each adjacent end of the stators 23A and 23B of the Y-axis fine-adjustment motor 21 becomes partially narrow. Consequently, with the mover 22 in the middle between the stators 23A and 23B, if the space is narrower than about 0.2 mm, the relative moving stroke in the Y direction of the fine-adjustment stage 3 may be too narrow and, in particular, the angle (rotating stroke) for which the fine-adjustment stage 3 can turn relative to the coarse-adjustment stage 4 may be too small.

The fine-adjustment stage 3 includes an X-axis movable mirror 27 in the form of a rod, which is fixed to the -X-direction end thereof. The movable mirror 27 is substantially parallel with the Y axis and mechanically out of contact with the coarse-adjustment stage 4. The -X-direction side of the movable mirror 27 is processed (finished) into a reflective surface having a very high flatness. With reference to Fig. 2, an X-axis laser interferometer 30 irradiates the reflective surface of the movable mirror 27 with biaxial laser beams for position measurement at an interval in the Y direction.

With reference to Fig. 2, the reflective surface of the movable mirror 27 is longer in the Y direction than the moving stroke of the fine-adjustment stage 3. The biaxial laser beams reflected by the reflective surface return to the laser interferometer 30, where each of them is then mixed with a reference beam (not shown) and converted photoelectrically. The interferometer 30 measures X coordinates XS1 and XS2 (hereinafter referred to as "measured values XS") at two points on the movable mirror 27. The measured values XS are supplied to the reticle stage drive system 46 (Fig. 4). As shown in Fig. 3, the optical axis of the biaxial laser beams extends through the optical axis AX at the center of the lighting area 2. The reticle stage drive system 46 calculates the X coordinate XF of the fine-adjustment stage 3 from the two X coordinates XS1 and XS2 and a predetermined offset $XS_{OF}$ as follows.

$$XF = (XS1 + XS2)/2 + XS_{OF} \qquad (2)$$

As an example, the offset $XS_{OF}$ is so set that the X coordinate XF is 0 with the coarse-adjustment stage 4 positioned in the middle of the moving stroke in the Y direction, with the movers 14A and 14B set exactly in parallel to the stators 15A and 15B so that the angle of rotation in the Θ direction is nearly 0, and with the fine-adjustment stage 3 positioned in the middle of each of the moving strokes relative to the coarse-adjustment stage 4 in the X and Y direction (initial state). For example, during the alignment of the reticle 3, the fine-adjustment stage 3 is so positioned that the X coordinate XF is nearly 0. This causes the X coordinate XF of the fine-adjustment stage 3 to vary in the vicinity of 0 even during scanning exposure.

With reference to Fig. 3, the coarse-adjustment stage 4 includes Y-axis movable mirrors 28A and 28B in the form of corner cubes fixed on the +Y-direction ends of two portions thereof. Likewise, the fine-adjustment stage 3 includes Y-axis movable mirrors 29A and 29B in the form of corner cubes fixed on the +Y-direction ends of two portions thereof. The movable mirrors 28A and 28B are positioned substantially in symmetry with respect to a straight line extending through the optical axis AX in parallel with the Y axis. The movable mirrors 28A and 28B are spaced at a distance DCT from each other. The movable mirrors 29A and 29B are positioned substantially in symmetry with respect to the straight line extending through the optical axis AX in parallel with the Y axis. The movable mirrors 29A and 29B are spaced at a distance DFT from each other. With reference to Fig. 2, the reticle base 5 includes Y-axis four-axis laser interferometers 31A, 31B, 32A and 32B fixed thereto, which irradiate the movable mirrors 28A, 28B, 29A and 29B, respectively, with laser beams for measurement. The laser beam reflected by each of these movable mirrors returns to the associated laser interferometer, where it is then mixed with a reference beam (not shown) and converted photoelectrically. The laser interferometers 31A and 31B measure the Y coordinates of the movable mirrors 28A and 28B, that is to say, the Y coordinates Y2A and Y2B at the two portions (spaced at the distance DCT) of the coarse-adjustment stage 4. These measured values are supplied to the reticle stage drive system 46 (Fig. 4). Likewise, the laser interferometers 32A and 32B measure the Y coordinates of the movable mirrors 29A and 29B, that is to say, the Y coordinates Y3A and Y3B at the two portions (spaced at the distance DFT) of the fine-adjustment stage 3. These measured values are supplied to the reticle stage drive system 46.

The reticle stage drive system 46 calculates the Y coordinate YC and angle of rotation $\Theta M$ (rad) of the coarse-adjustment stage 4 from the two Y coordinates Y2A and Y2B, a predetermined offset $YS2_{OF}$ and the distance DCT between the two portions of this stage 4 as follows.

$$YC = (Y2A + Y2B)/2 + YS2_{OF} \qquad (3)$$

$$\Theta M = (Y2A - Y2B)/DCT \qquad (4)$$

This is based on the assumption that, with the movers 14A and 14B of the Y-axis coarse-adjustment linear motors 13A and 13B of the coarse-adjustment stage 4 in parallel to the stators 15A and 15B, respectively (the angle in the $\Theta$ direction is 0), in advance, the offset of the laser interferometers 31A and 31B has been so adjusted that the Y coordinates Y2A and Y2B are identical. The offset $YS2_{OF}$ is so set that the Y coordinate YC is 0 in the foregoing initial state as an example.

In parallel thereto, the reticle stage drive system 46 calculates the Y coordinate YF and angle of rotation $\Theta M$ (rad) of the fine-adjustment stage 3 from the two Y coordinates Y3A and Y3B, a predetermined offset $YS3_{OF}$ and the distance DFT between the two portions of this stage 3 as follows.

$$YF = (Y3A + Y3B)/2 + YS3_{OF} \qquad (5)$$

$$\Theta M = (Y3A - Y3B)/DFT \qquad (6)$$

This is based on the assumption that, with the angle in the $\Theta$ direction of the coarse-adjustment stage 4 zero in advance, and with the middle portion of the mover 22 of the Y-axis fine-adjustment motor 21 parallel to the adjacent ends of the stators 23A and 23B (the relative angle of rotation of the fine-adjustment stage 3 is 0), the offset of the laser interferometers 32A and 32B has been so adjusted that the Y coordinates Y3A and Y3B are identical. The offset $YS3_{OF}$ is so set that the Y coordinate YF is 0 in the foregoing initial state as an example. The relative coordinate $\Delta YF$ which is the (finite) difference between the Y coordinates YC and YF of the stages 3 and 4, respectively, and the relative angle of rotation $\Delta \theta M$ of the fine-adjustment stage 3 relative to the coarse-adjustment stage 4 are calculated as follows.

$$\Delta YF = YC - YF \qquad (7)$$

$$\Delta \theta M = \Theta M - \theta M \qquad (8)$$

This embodiment is so set that, when both of the Y-axis relative coordinate $\Delta YF$ and relative angle of rotation $\Delta \theta M$ of the fine-adjustment stage 3 are 0, the mover 22 of the Y-axis fine-adjustment motor 21 is positioned in the middle between the stators 23A and 23B in the Y direction, and the middle portion of the mover 22 is parallel to the adjacent ends of the stators 23A and 23B. Therefore, for example, during the alignment of the reticle 3, the fine-adjustment stage 3 is so positioned that both of the relative coordinate $\Delta YF$ and relative angle of rotation $\Delta \theta M$ are 0. This causes both of the relative coordinate $\Delta YF$ and relative angle of rotation $\Delta \theta M$ of the fine-adjustment stage 3 to vary in the vicinity of 0 during scanning exposure as well.

The coordinate calculation according to the expressions (2) - (8) is carried out consecutively at a predetermined sampling rate from alignment to exposure. On the basis of the consecutively calculated coordinate and angle of rotation of the coarse-adjustment stage 4, the control information from the main control system 37, etc., the reticle stage drive system 46 (Fig. 4) drives the Y-axis coarse-adjustment linear motors 13A and 13B, the X-axis fine-adjustment motors 8A and 8B, and the Y-axis fine-adjustment motor 21.

The laser interferometers 32A and 32B for coordinate measurement in the Y direction (scanning direction) for the fine-adjustment stage 3 as well. The values measured by the laser interferometers 32A and 32B are the bases for finding the relative position in the Y direction and the relative angle of rotation of the fine-adjustment stage 3 relative to the coarse-adjustment stage 4. Alternatively, biaxial displacement sensors such as photoelectric, magnetic or other linear encoders might directly measure the relative displacement of the fine-adjustment stage 3 in the Y direction relative to the coarse-adjustment stage 4. The results of this measurement may be the bases for finding the relative position in the Y direction and the relative angle of rotation of the fine-adjustment stage 3. This makes it possible to omit the laser interferometers 32A and 32B for the fine-adjustment stage 3. Instead of the laser interferometers 32A and 32B for the fine-adjustment stage 3, the laser interferometers 31A and 31B for the coarse-adjustment stage 4 might be omitted, the relative position in the Y direction and the relative angle of rotation of this stage 4 might be calculated from the accurately measured position of the fine-adjustment stage 3, the relative position measured by the displacement sensors, etc.

An example of the operation of the reticle stage during alignment and scanning exposure will be described below.

With reference to Fig. 3, on the assumption that no reticle R is placed on the fine-adjustment stage 3, the stages 3 and 4 are positioned in the initial state. In this state, the center line of the middle portion of the mover 21 of the Y-axis fine-adjustment motor 21 coincides with the center lines of the stators 23A and 23B, and the fine-adjustment stage 3 is positioned in the middle of the moving stroke in each of the Y and X directions.

Then, as shown in Fig. 5(a), a reticle loader (not shown) places on the fine-adjustment stage 3 a reticle R in a pre-aligned state, in which it is positioned on an outline basis. This is based on the assumption that a portrayal error has inclined the master pattern in the pattern area PA of the reticle R at an angle θ1 with respect to the coordinate system defined by the orthogonal end faces of the glass substrate of the reticle R. The portrayal error is an inclination of about 2 mm at the maximum per 100 mm in length of the end faces of the glass substrate (an angle of about 1 degree). Accordingly, the angle θ1 is about 1 degree at the maximum.

The reticle R has a pair of alignment marks AM1 and AM2 formed on both sides of the pattern area PA. The positions of the alignment marks AM1 and AM2 can be detected by a pair of reticle alignment microscopes (not shown), which are provided over the reticle R. The detection finds the angle θ1 and the positions in the X and Y directions of the master pattern in the pattern area PA. With reference to Fig. 1, the wafer stage 34 includes a fiducial mark member (not shown) having a pair of fiducial marks formed thereon. The pair of fiducial marks is moved to a position substantially conjugate with that of the alignment marks AM1 and AM2. The moved pair of fiducial marks, that is to say, the coordinate system of the wafer stage 34 is the basis for finding the angle θ1 and the amounts of displacement in the X and Y directions of the master pattern.

Next, as shown in Fig. 5(b), with the positional relation between the stages 3 and 4 maintained, the coarse-adjustment stage 4 is turned around the shaft 7 with respect to the Y-axis slider 6 so as to cancel the angle θ1. In the meantime, the relative position of the fine-adjustment stage 3 relative to the coarse-adjustment stage 4 is corrected by driving the X-axis fine-adjustment motors 8A and 8B and the Y-axis fine-adjustment motor 21 so as to cancel the amounts of displacement in the X and Y directions of the master pattern. The coarse-adjustment stage 4 can be turned by changing the balance of thrust between the Y-axis coarse-adjustment linear motors 13A and 13B.

Thereafter, until the reticle R is removed, the angle of rotation of the coarse-adjustment stage 4 is maintained by the servo system including the laser interferometers 31A and 31B (Fig. 2) as sensors and the Y-axis coarse-adjustment linear motors 13A and 13B as actuators. In order to correct the position of the master pattern of the reticle R in the X direction, the position of the coarse-adjustment stage 4 in the Y direction may be corrected.

Next, with reference to Fig. 1, the measurement of the positions of the alignment marks on the wafer W on the wafer stage 34 with wafer alignment sensors (not shown) finds the array coordinates of the shot areas of the wafer W on the coordinate system of the wafer stage 34. These array coordinates are the bases for positioning the shot areas of the wafer W in the scanning starting position. When the synchronous scanning of the reticle R and wafer W starts, the coarse-adjustment stage 4 and wafer stage 34 are driven in the Y direction at the speed ratio which is the projection ratio β of the projection optical system PL so as to maintain the relation between a predetermined time and a predetermined position. Alternatively, the wafer stage 34 is driven at a constant speed on the basis of a function representing the predetermined time and position. In this case, as shown in Fig. 5(b), the coarse-adjustment stage 4 is driven with relatively low accuracy in the scanning direction S (Y direction) so as to follow the wafer stage 34. The fine-adjustment stage 3 is driven minutely in the X, Y and rotating directions by the X-axis fine-adjustment motors 8A and 8B and Y-axis fine-adjustment motor 21 so as to cancel the synchronization error between the reticle R and wafer W.

The angular displacement θ1 of the master pattern relative to the reticle R is corrected in advance by turning the coarse-adjustment stage 4. Consequently, in the Y-axis fine-adjustment motor 21, the parallelism between the mover 22 and stators 23A and 23B is kept high. This makes it possible to narrow the space between the mover 22 and stators 23A and 23B. Therefore, if an EI-core motor is used as the Y-axis fine-adjustment motor 21, it is possible to increase the rigidity (holding power) of the fine-adjustment stage 3 relative to the coarse-adjustment stage 4 without greatly increasing the current flowing through the coils 23A and 23B, that is to say, with low heat generation. Besides, in the case of the synchronization error being corrected, it is possible to obtain a high follow-up speed with a high thrust. Accordingly, because the synchronization error is reduced, it is possible to obtain high superposition accuracy for superposition exposure.

The X-axis fine-adjustment motors 8A and 8B using Lorentz force drive the fine-adjustment stage 3 relative to the coarse-adjustment stage 4 in the non-scanning (X) direction. Because the movement of the coarse-adjustment stage 4 in the causes little inertia force to act in the scanning direction, the motors using Lorentz force correct the synchronization error at high speed with high accuracy.

With reference to Fig. 2, while the coarse-adjustment stage 4 is moving in the Y direction during scanning exposure, the motor balancers 18A and 18B move in the opposite direction to the moving direction of the coarse-adjustment stage so as to cancel the reaction force. Consequently, little vibration is generated in the exposure apparatus. Ideally, it is preferable that the stators 15A and 15B of the Y-axis coarse-adjustment linear motors 13A and 13B move in such a manner that the center of gravity of the system including the stages 4 and 3, the linear motors 13A and 13B, and the motor balancers 18A and 18B does not move on the XY plane. For example, however, if the horizontal guide surface 5a is not completely horizontal, the center of gravity is moved to a lower position by gravity. Besides, because the sliding resistance of an air bearing may make a fine difference between traveling direction, the center of gravity tends to deflect (deviate) gradually in the +Y or -Y direction.

Therefore, the displacements of the stators 15A and 15B which are measured by the linear encoders 40A and 40B as position sensors are corrected by means of the coils 45A and 45B of the positioning plates 44A and 44B.

Because the mover 22 of the Y-axis fine-adjustment motor 21 is fixed to the fine-adjustment stage 3, this stage 3 can be lightweight. Alternatively, the mover 22 of the Y-axis fine-adjustment motor 21 might be fixed to the coarse-adjustment stage 4, while the stators 23A and 23B might be fixed to the fine-adjustment stage 3.

The X-axis fine-adjustment motors 8A and 8B using Lorentz force are used as motors for positioning the fine-adjustment stage 3 in the non-scanning direction relative to the coarse-adjustment stage 4. The X-axis fine-adjustment motors 8A and 8B might be replaced by conventional linear motor type biaxial actuators using electromagnetic force, or EI-core biaxial motors. Instead of the biaxial motors for actuation in the non-scanning direction, with reference to Fig. 3, the EI-core Y-axis fine-adjustment motor 21 might be disposed biaxially at a predetermined interval in the X direction, while one of the X-axis fine-adjustment motors 8A and 8B might be used uniaxially. Instead of the EI-core motor type Y-axis fine-adjustment motor 21, a motor might be used where, for example, the stator 23B is replaced by a spring which keeps pulling the mover 22 with constant force in the -Y direction. Alternatively, a pair of plates of magnetic substance might be fixed to the +Y-direction and -Y-direction side faces of the fine-adjustment stage 3. The plates of magnetic substance could each be attracted (or repelled) by an actuator on the coarse-adjustment stage 4. The (finite) difference between the pair of attraction forces could relatively drive the fine-adjustment stage 3 in the Y direction.

As shown in Figs. 6 and 7, the projection exposure apparatus includes a mechanism for attraction-holding a reticle.

Fig. 6 is a perspective view showing the fine-adjustment stage 3 of the reticle stage with the reticle R removed from the stage 3. With reference to Fig. 6, the fine-adjustment stage 3 includes a first reticle attracting portion 51, a second reticle attracting portion 52 and a third reticle attracting portion 53 in the form of narrow ridges provided thereon and extending in the scanning (Y) direction S. The reticle attracting portions 51, 52 and 53 are positioned on both sides of the opening 3a which are perpendicular to the non-scanning (X) direction. Exposure light passes through the stage opening 3a. The fine-adjustment stage 3 also includes charge eliminators 57A, 57B, 57C and 57D positioned thereon out of contact with the reticle R. The charge eliminators 57A and 57B are near to the reticle attracting portion 51. The charge eliminators 57C and 57D are near to the reticle attracting portions 52 and 53, respectively. The charge eliminators 57A - 57D are ionizers for generating ions by means of corona discharge or faint X rays. The first reticle attracting portion 51 has a vacuum pocket 51a in the form of a narrow recess formed in the top thereof and extending in the scanning direction S. A unipolar electrode 54 for electrostatic attraction is disposed in the center of the vacuum pocket 51a.

Fig. 7 is an enlarged cross section along line A-A of Fig. 6. With reference to Fig. 7, the fine-adjustment stage 3 has an exhaust hole 58 formed therethrough. The vacuum pocket 51a of the reticle-attracting portion 51 is connected by the exhaust hole 58 and highly flexible piping 59 to a vacuum pump 60. The members from the vacuum pocket 51a to the vacuum pump 60 compose a vacuum chuck. The electrode 54 fixed in the vacuum pocket 51a includes electrically conductive electrodes 54a and 54c and a thin insulator 54b interposed between them. The electrodes 54a and 54c are connected by signal cables in series to an external DC power supply 61 for generating a DC voltage between 200 and 1,000 V and a switch circuit 62. The electrode 54, DC power supply 61, switch circuit 62, etc. compose an electrostatic chuck. The top of the electrode 54 is so machined (finished) that it is accurately flush with the top of the reticle-attracting portion 51. Thus, in the reticle-attracting portion 51, the attracting portions of the vacuum and electrostatic chucks are disposed in parallel.

With reference to Fig. 6, likewise, the second and third reticle attracting portions 52 and 53 have vacuum pockets 52a and 53a, respectively, in which electrodes 55 and 56 for electrostatic attraction are disposed respectively. In each of the reticle attracting portions 52 and 53, also, a vacuum chuck and an electrostatic chuck are provided in parallel. The fine-adjustment stage 3 is made of ceramic material having a small coefficient of thermal expansion. The reticle-attracting portions 51 - 53 are made of ceramic material having a specific resistance adjusted to about $10^{14}$ $\Omega \cdot$cm. Alternatively, the fine-adjustment stage 3 and reticle-attracting portions 51 - 53 might be integrally molded out of ceramic material, and thereafter the electrodes 54 - 56 might be embedded in the reticle- attracting portions 51 - 53.

With reference to Fig. 7, until a reticle R is placed on the reticle-attracting portion 51, the vacuum pump 60 does no suction, with the switch circuit 62 kept open. When, as shown with two-dot chain lines, the reticle R is placed on the reticle-attracting portion 51, the vacuum pump 60 is caused to start suction. At the same time, the switch circuit 62 is closed to apply a voltage between the electrodes 54a and 54c in such a manner that the voltage at the electrode 54c is higher. This causes the contact part, which is in contact with the vacuum pocket 51a, of the attraction surface (underside) of the reticle R to be sucked toward the fine-adjustment stage 3. In the meantime, those parts of the contact surface which are in contact with the electrodes 54a and 54c are charged positively and negatively, respectively, so that the electrode 54 electrostatically attracts the reticle R. At the other reticle attracting portions 52 and 53, also, vacuum attraction and electrostatic attraction take place in parallel. Consequently, the reticle R is fixed on the fine-adjustment stage 3 more stably with higher attraction force than by only vacuum. Accordingly, even if the reticle R is scanned in the Y direction at higher speed for higher throughput in the exposure process, the reticle R does not shift. This results in high superposition accuracy, making it possible to mass-produce high-performance devices.

Because the electrodes 54 - 56 for electrostatic attraction are disposed in the vacuum pockets 51a - 53a, it is possible to increase the attracting force for the reticle R without increasing the area of the contact part of the reticle R. Because the vacuum pockets 51a - 53a and the electrodes 54 - 56 extend in the scanning direction, the attracting force for the direction is high. In this respect, also, the reticle R can be moved at high speed in the scanning direction.

The magnitude of electrostatic attraction depends on the ambient humidity at the same applied voltage. The attraction at a humidity of 50% is about half the attraction at a humidity of 25%. In this respect, the space around the electrode 54, which develops electrostatic attraction, is an approximate vacuum. This makes it possible to develop stable electrostatic attraction without being influenced by the moisture in the atmosphere.

In order to remove the reticle R from the fine-adjustment stage 3, with reference to Fig. 7, the attraction force is eliminated by stopping the vacuum pump 60, which is connected to the vacuum pocket 51a, from doing vacuum attraction, and the electrostatic attraction is eliminated by changing the voltage, applied to the electrode 54, to 0 volt. However, the reticle R and the reticle attracting portion 51 are slightly charged, and these slightly charged parts would attract a very small quantity of dust or other foreign substances suspending in the surrounding gas (air, nitrogen gas, etc.). Therefore, the charge eliminators 57A and 57B emit positive and negative ions into the gas to neutralize the charge (electrification). Likewise, at the other reticle attracting portions 52 and 53, the charge eliminators 57C and 57D, respectively, neutralize the charge to prevent foreign substances from sticking to the reticle R, the fine-adjustment stage 3 and the reticle attracting portions 51 - 53.

The attraction mechanism of this embodiment might be applied to the reticle stage of a batch-exposure projection exposure apparatus. In a case where a scanning-exposure projection exposure apparatus transfers a mask pattern onto a glass substrate for a liquid crystal display element, the attraction mechanism might be used as a mechanism for attraction-holding the glass substrate.

The projection exposure apparatus according to this embodiment might be used suitably in a case where a plasma display or a thin-film magnetic head image sensor (a CCD etc.) is manufactured, or a case where a reticle or a mask for use with an exposure apparatus for manufacturing a semiconductor device or another device is manufactured by means of an exposure apparatus using far ultraviolet (DUV) light, vacuum ultraviolet (VUV) light or the like.

The stage apparatus according to the present invention may be used as the reticle stage of an exposure apparatus using extreme ultraviolet (EUV) light such as a soft X ray with a wavelength of about 5 - 15 nm as exposure light. This stage apparatus might also be used as the mask stage of a charged particle beam transcriber using a charged particle beam such as an electron beam as an exposure beam. An EUV exposure apparatus is used with a reflection mask as a reticle, and includes a reflection type projection optical system consisting of a plurality of particle elements (mirrors), which may range from 3 to 8 in number. The present invention may be applied to the wafer stage of a projection exposure apparatus. The projection exposure apparatus according to this embodiment is a step-and-scan system, but the present invention may also be applied to a projection exposure apparatus which is a stepper or another batch exposure system. The present invention may further be applied to a step-and-stitch reduction-projection exposure apparatus.

The illuminating light for exposure may be a higher harmonic obtained by amplifying by means of a fiber amplifier, which may be doped with erbium (Er) or both erbium and ytterbium (Yb), a single-wavelength laser beam in an infrared region or a visible region that is emitted from a DFB semiconductor laser or a fiber laser, and by converting the wavelength of the amplified beam with a nonlinear optical crystal so that the beam is ultraviolet light. If the single-wavelength laser beam has an oscillation wavelength ranging between 1.544 and 1.553 $\mu$m, an octuple harmonic is obtained which ranges between 193 and 194 nm, that is to say, ultraviolet light is obtained which has substantially the same wavelength as an ArF excimer laser beam. If the single-wavelength laser beam has an oscillation wavelength ranging between 1.57 and 1.58 $\mu$m, a decuple harmonic is obtained which ranges between 157 and 158 nm, that is to say, ultraviolet light is obtained which has substantially the same wavelength as an $F_2$ laser beam.

In a case where the illuminating light for exposure is an excimer laser beam or another far ultraviolet ray, quartz ($SiO_2$), fluorite ($CaF_2$) or other material which transmits far ultraviolet rays is used for the projection optical system etc. The magnification of the projection optical system is not limited to reduction, but may be equality or enlargement.

The projection optical system may be any of a dioptric system, a catoptric system, and a catadioptric system consisting of a dioptric lens and a concave mirror or another catoptric element in combination. The catadioptric system may be an optical system as disclosed in United States Patent No. 5, 788, 229. This optical system includes two catoptric elements, at least one of which is a concave mirror, and two or more dioptric elements. These elements are disposed on a straight optical axis without being bent. The disclosure in this U.S. patent is incorporated herein by reference as far as the incorporation is allowable according to domestic laws of the states designated or elected in this international application.

The exposure apparatus according to this embodiment can be produced by assembling the stage apparatus from a number of parts such as the fine-adjustment stage 3, the coarse-adjustment stage 4, the Y-axis coarse-adjustment linear motors and the Y-axis fine-adjustment motor, optically adjusting the projection optical system PL, which consists of a plurality of lenses, and making total adjustment (electric adjustment, operation checks, etc.).

It is preferable that the exposure apparatus be manufactured in a clean room where the temperature, the cleanness, etc. are controlled.

The semiconductor device is produced through the step of designing the function and/or performance of the device, the step of producing a reticle based on the designing step, the step of manufacturing a wafer from silicon material, the step of exposing the wafer through the pattern of the reticle by means of the exposure apparatus according to this embodiment, the step of assembling the device (including the dicing, bonding and packaging steps), the step of inspecting the assembled device, and other steps.

The present invention may also be applied to the stage system of a proximity type exposure apparatus. Thus, the present invention is not limited to this embodiment, but may be embodied into various forms without departing from the spirit of the invention. All the disclosure in the specification, claims, drawings and abstract of Japanese Patent Application No. 11-120445 filed on 27 April 1999 is entirely incorporated herein by reference as it is.

INDUSTRIAL APPLICABILITY

The first stage apparatus according to the present invention includes a coarse-adjustment stage, a fine-adjustment stage and an actuator. The actuator includes a magnetic substance and a pair of electromagnetic members. The actuator can drive the fine-adjustment stage relative to the coarse-adjustment stage with low heat generation and great thrust.

The coarse-adjustment stage may be supported by a rotational support rotatably relative to a guide. In this case, it is possible to substantially increase the angle of rotation of the fine-adjustment stage without enlarging the range of relative movement of this stage.

The second stage apparatus according to the present invention makes it possible to use vacuum attraction and electrostatic attraction together. This makes it possible to hold a reticle or another carried object with great attraction force without enlarging the area of the contact part of the reticle.

The third stage apparatus according to the present invention can drive a stage stably at high speed.

The first exposure apparatus according to the present invention includes the first or second stage apparatus. For example, this exposure apparatus can make exposure at high throughput by moving a mask at high speed with great thrust, or hold a mask with great holding power. The mask held with great holding power does not shift even if scanned at high speed. This results in high superposition accuracy.

The second exposure apparatus according to the present invention includes the third stage apparatus. This makes it possible to drive the stage stably at high speed, reduce the superposition error and improve the throughput.

The device producing method according to the present invention is used with the first or second exposure apparatus. This makes it possible to produce high-precision devices at high throughput.

## Claims

1. A stage apparatus comprising a coarse-adjustment stage and a fine-adjustment stage, the coarse-adjustment stage being supported so as to be movable relative to a base within a stroke in a predetermined direction, the fine-adjustment stage being supported so as to be movable respect to the coarse-adjustment stage within a stroke shorter than the stroke of the coarse-adjustment stage at least in the predetermined direction, the stage apparatus, **characterized by** comprising:

   a magnetic substance fixed to one of the fine-adjustment and coarse-adjustment stages and arranged in a direction substantially perpendicular to the predetermined direction; and
   a pair of electromagnetic members which develops driving force on the magnetic substance, the electromagnetic members being fixed to the other of the two stages, the magnetic substance being interposed between the electromagnetic members.

2. The stage apparatus defined in claim 1, **characterized in that**:

   the magnetic substance is fixed on the fine-adjustment stage;
   the pair of electromagnetic members is fixed on the coarse-adjustment stage; and
   the pair of electromagnetic members each having an E-shaped core and a coil wound on the core.

3. The stage apparatus defined in claim 1, **characterized by** further comprising:

   a guide disposed so as to be movable relative to the base in the predetermined direction;
   a rotational support which supports the coarse-adjustment stage rotatably relative to the guide; and
   a pair of driving units which drives the coarse-adjustment stage out of contact with the base in the predetermined direction.

4. The stage apparatus defined in claim 1, **characterized by** further comprising a balancer disposed adjacently to the base so as to be movable while conservation of momentum is maintained in conjunction with the coarse-adjustment stage substantially in the predetermined direction.

5. A stage apparatus comprising a base and a movable stage, on which an object to be carried can be mounted, the movable stage being disposed movably in a predetermined direction relative to the base, **characterized by** further comprising:

   a suction device including an opening formed in part of a contact surface for contact with the object on the movable stage and a suction apparatus for sucking gas from the opening; and an electrostatic attraction device which has an electrode disposed in the opening;

   wherein the suction device and the attraction device are used together to fix the object to the movable stage.

6. An exposure apparatus for exposing a substrate with a pattern, the exposure apparatus including a mask stage apparatus which moves while holding a mask thereon, on which the pattern is formed, and a substrate stage apparatus which moves while holding the substrate thereon, **characterized in that**;
   the stage apparatus defined in any one of Claims 1 - 5 is used as at least one of the mask stage apparatus and the substrate stage apparatus.

7. A stage apparatus **characterized by** comprising:

   a stage movable in a predetermined direction;
   a driving unit which drives the movable stage in the predetermined direction includes a first mover and a second mover both provided on the movable stage, and a first stator and a second stator which cooperates with the first and second movers, respectively;
   a first balance stage which moves in the direction opposite to the predetermined direction as the movable stage moves, and is fixed to the first stator; and
   a second balance stage which is provided independently of the first balance stage to move in the direction opposite to the predetermined direction as the movable stage moves, and is fixed to the second stator.

8. The stage apparatus defined in Claim 7, characterized further comprising position-adjusting mechanism which adjusts the positions of the first and second balance stages, respectively.

9. The stage apparatus defined in Claim 8, **characterized in that** the position-adjusting mechanism includes a position detector which detects the positions of the first and second balance stages.

10. The stage apparatus defined in Claim 8, **character-**

**ized in** position-adjusting mechanism includes a second driving unit which drives the first and second balance stages.

11. The stage apparatus defined in Claim 7, **characterized in that** a plane on which the movable stage moves is different from a plane on which the first and second balance stages moves.

12. The stage apparatus defined in Claim 7, **characterized by** further comprising a support which movably supports the movable stage and movably supports the first and second balance stages.

13. The stage apparatus defined in Claim 7, **characterized by** further comprising a stage position detector which detects the position of the movable stage and at least part of which is provided on the movable stage.

14. The stage apparatus defined in Claim 7, **characterized in that** the movable stage includes:

    a first stage fitted with the first and second movers; and
    a second stage movable relative to the first stage.

15. The stage apparatus defined in Claim 14, **characterized by** further comprising:

    a magnetic substance fitted to the second stage; and
    an electromagnetic member which is provided on the first stage to develop driving force on the magnetic substance.

16. An exposure apparatus for exposing a substrate with a pattern, the exposure apparatus including a mask stage which moves while holding a mask thereon, on which the pattern is formed, and a substrate stage which moves while holding the substrate thereon, **characterized in that**;
    the stage apparatus defined in any one of Claims 7 - 15 is used as at least one of the mask stage and the substrate stage.

17. A method for producing a device through an exposure process for exposing a substrate with a mask pattern, **characterized in that** the exposure process is carried out by the exposure apparatus defined in Claim 16.

# Fig. 1

# Fig. 2

## Fig. 3

# Fig. 4

# Fig. 5

## (a)

## (b)

## Fig. 6

## Fig. 7

## INTERNATIONAL SEARCH REPORT

| | International application No. |
|---|---|
| | PCT/JP00/02257 |

| A. CLASSIFICATION OF SUBJECT MATTER |
|---|
| Int.Cl$^7$  H01L21/68, H01L21/027, G03F7/20, G03F9/00 |

According to International Patent Classification (IPC) or to both national classification and IPC

| B. FIELDS SEARCHED |
|---|
| Minimum documentation searched (classification system followed by classification symbols) |
| Int.Cl$^7$  H01L21/68, H01L21/027, G03F7/20, G03F9/00 |

Documentation searched other than minimum documentation to the extent that such documents are included in the fields searched
Jitsuyo Shinan Koho        1926-1996     Toroku Jitsuyo Shinan Koho  1994-2000
Kokai Jitsuyo Shinan Koho  1971-2000     Jitsuyo Shinan Toroku Koho  1996-2000

Electronic data base consulted during the international search (name of data base and, where practicable, search terms used)

| C. DOCUMENTS CONSIDERED TO BE RELEVANT | | |
|---|---|---|
| Category* | Citation of document, with indication, where appropriate, of the relevant passages | Relevant to claim No. |
| X | Microfilm of the specification and drawings annexed to the request of Japanese Utility Model Application | 1,3,6 |
| Y | No.181132/1981 (Laid-open No.85345/1983) (Hitachi, Ltd.), 09 June, 1983 (09.06.83), page 1, line 12 to page 3, line 3,  page 4 lines 3-10 (Family: none) | 2,4,5,6-17 |
| Y | US, 5537186, A (Canon Kabushiki Kaisha), 16 July, 1996 (16.07.96) Column 9, lines 8-45 & JP, 7-183192, A (Canon Inc.), 21 July, 1995 (21.07.95), Column 4, line 39 to column 5, line 23 (Family: none) | 2,6 |
| Y | JP, 3-107639, A (Nikon Corporation), 08 May, 1991 (08.05.91), page 2, lower right column, line 2 to page 3, upper right column, line 11 (Family: none) | 4,6-17 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier document but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 05 July, 2000 (05.07.00) | 18 July, 2000 (18.07.00) |

| Name and mailing address of the ISA/ | Authorized officer |
|---|---|
| Japanese Patent Office | |
| Facsimile No. | Telephone No. |

Form PCT/ISA/210 (second sheet) (July 1992)

## INTERNATIONAL SEARCH REPORT

| International application No. |
| --- |
| PCT/JP00/02257 |

C (Continuation).   DOCUMENTS CONSIDERED TO BE RELEVANT

| Category* | Citation of document, with indication, where appropriate, of the relevant passages | Relevant to claim No. |
| --- | --- | --- |
| Y | JP, 10-116886, A (Nikon Corporation), 06 May, 1998 (06.05.98), Column 1, lines 2 to 6 (Family: none) | 5,6 |
| Y | JP, 62-207165, A (Omron Tateishi Electronics Co.), 11 September, 1987 (11.09.87), page 1, lower right column, lines 1-8, Fig. 3 (Family: none) | 7-17 |
| Y | JP, 7-22352, A (Canon Inc.), 24 January, 1995 (24.01.95), Column 4, line 24 to Column 5, line 1 (Family: none) | 9,13, 16,17 |

Form PCT/ISA/210 (continuation of second sheet) (July 1992)